# EUROPÄISCHE PATENTSCHRIFT

(11) **EP 0 947 002 B1**
(45) Veröffentlichungstag und Bekanntmachung des Hinweises auf die Patenterteilung: **04.02.2004**
(21) Anmeldenummer: 97950163.2
(22) Anmeldetag: 11.11.1997
(51) Int. Cl.: H01L 41/083

(54) **PIEZOAKTUATORISCHES ANTRIEBS- ODER VERSTELLELEMENT**
PIEZO-ELECTRIC DRIVING OR ADJUSTING ELEMENT
ELEMENT D'ENTRAINEMENT OU DE REGLAGE PIEZO-ELECTRIQUE

(30) Priorität: 12.11.1996 DE 19646511
(43) Veröffentlichungstag der Anmeldung: 06.10.1999
(73) Patentinhaber: MARCO SYSTEMANALYSE UND ENTWICKLUNG GmbH, D-85221 Dachau (DE)
(72) Erfinder: REUTER, Martin, D-85221 Dachau (DE)
(74) Vertreter: Bock, Gerhard
(86) Internationale Anmeldenummer: PCT/EP1997/006266
(87) Internationale Veröffentlichungsnummer: WO 1998/021759

(56) Entgegenhaltungen:
- US-A- 4 639 630
- PATENT ABSTRACTS OF JAPAN vol. 010, no. 306 (E-446), 17.Oktober 1986 & JP 61 121375 A (CANON INC), 9.Juni 1986,

## Beschreibung

Die Erfindung betrifft ein piezoaktuatorisches Antriebs- oder Verstellelement, welches insbesondere zur Erzeugung von Kippbewegungen in hohen Frequenzbereichen Verwendung findet.

Piezoelektrische Antriebs- und Verstellelemente sind bereits bekannt. Der vorliegender Erfindung zugrundeliegende Antriebs- bzw. Verstellelemente sind solche, welchen als aktuatorischen Körper piezoelektrische Stapelantriebe einsetzen. Solche Antriebe sind mit Ihren Vorteilen z.B. ausführlich in F & M Feinwerktechnik, Mikrotechnik, Messtechnik, 104 Jg. 1996, Carl Hanser Verlag München, S. 68ff. beschrieben. Ebenfalls beschreibt DE 44 45 642 A1 einen solchen Antrieb, bei dem eng benachbarte piezoelektrische Doppelstapel zum Einsatz gelangen und der für vielfältigste Antriebsaufgaben einsetzbar ist. Ein grundsätzlicher Nachteil bei allen bekannten Stapelantrieben besteht darin, daß die erforderlichen äußeren elektrischen Stapelkontaktierungen (vgl. z.B. DE 42 24 284 Al) einer erheblichen mechanischen Belastung sowohl im statischen als auch im dynamischen Betrieb unterliegen. Die Stapel sind aus einer Vielzahl übereinander geschichteter, miteinander verbundener und jeweils beidseitig flächig kontaktierter piezoelektrischer Folien aufgebaut. Die äußere Kontaktierung der einzelnen Folien untereinander erfolgt jeweils an sich gegenüberliegenden Längsseiten der Stapel durch eine durchgängige Elektrode, insbesondere eine Lotschicht. Diese Elektroden, als auch feldfreie interaktive Isolationsbereiche sind während der Dehnung und Kontraktion der Stapel höchsten mechanischen und elektrischen Belastungen ausgesetzt. Beim Betrieb solcher Stapel mit Impulsströmen im Amperebereich und Frequenzen im kHz-Bereich erfahren übliche Stapel Dehnungen von 1...2 ‰, was die Lastwechselzyklen auf kleiner als 10⁹ deutlich begrenzt. Weiterhin nachteilig bei diesen bekannten Antrieben ist der nicht unerhebliche mechanische Aufwand, um die durch die Stapel erzeugten reinen Translationsbewegungen in Kippbewegungen umzusetzen (vgl. bspw. DE 44 45 642 A1 oder EP 0 574 945 A1).
Weiterhin sind nach dem Stand der Technik Bauformen für andere Anwendungen bekannt. Beispielsweise beschreibt DE 196 05 214 A1 ein Ultraschallantriebselement, das typischerweise bei Frequenzen von > 20 kHz arbeitet. In dieser Betriebsart treten nur sehr geringe Hübe und damit geringe mechanische Dehnungen der äußeren Kontakte auf, weshalb dort auch keine besondere Vorschrift für die Anordnung der Elektroden angegeben und erforderlich ist.

Der Erfindung liegt die Aufgabe zugrunde, ein piezoaktuatorisches Antriebs- oder Verstellelement mit einer Laminatstruktur anzugeben, das im d₃₃-Modus betrieben, die erforderlichen elektrischen Anschlußkontaktierungen einer wesentlich verminderten mechanischen Belastung aussetzt und insbesondere direkte Kippbewegungen, ohne weitere Mittel zur Bewegungswandlung realisiert.
Die Aufgabe der Erfindung wird durch die Merkmale des Patentanspruchs 1 gelöst. Das Wesen der Erfindung besteht darin, daß ein erster und ein zweiter Bereich aus piezoelektrisch aktivem, insbesondere piezokeramischem Material bestehender, in Laminatstruktur ausgeführter Stapel vorgesehen sind zwischen denen ein dritter Bereich angeordnet ist, der Gebiete beinhaltet, die vom elektrischen Feld, herrührend von den spannungsbeaufschlagten flächigen Laminatkontaktierungen, unerfaßt sind und die äußeren Elektrodenanschlüsse der beiden piezoelektrisch aktiven Bereiche weitestgehend in Richtung genannten feldfreien Gebietes verlagert sind, wobei der dritte Bereich mit dem ersten und zweiten Bereich zumindest formschlüssig, bevorzugt stoffschlüssig verbunden ist.

Die Erfindung soll nachstehend anhand von Ausführungsbeispielen und schematischer Zeichnungen näher erläutert werden. Es zeigen:
- Fig. 1: einen ersten schematischen Aufbau eines gemäß der Erfindung ausgebildeten piezoaktuatorischen Antriebs- oder Verstellelementes,
- Fig. 2: eine bevorzugte Ausbildung nach Fig. 1,
- Fig. 3: eine bevorzugte Verwendung einer Ausführung nach Fig. 2 für bspw einen / Kippspiegelantrieb,
- Fig. 4: eine bevorzugte Ausbildung der einzelnen Laminatftächenelektroden gemäß der Erfindung,
- Fig. 5: eine kleinste Stapelbreite, die sich aus einer Ausführung nach Fig. 4 herstellen läßt und
- Fig. 6: und 7 weitere Variationsmöglichkeiten von Laminatflächen-elektrodenausführungen.

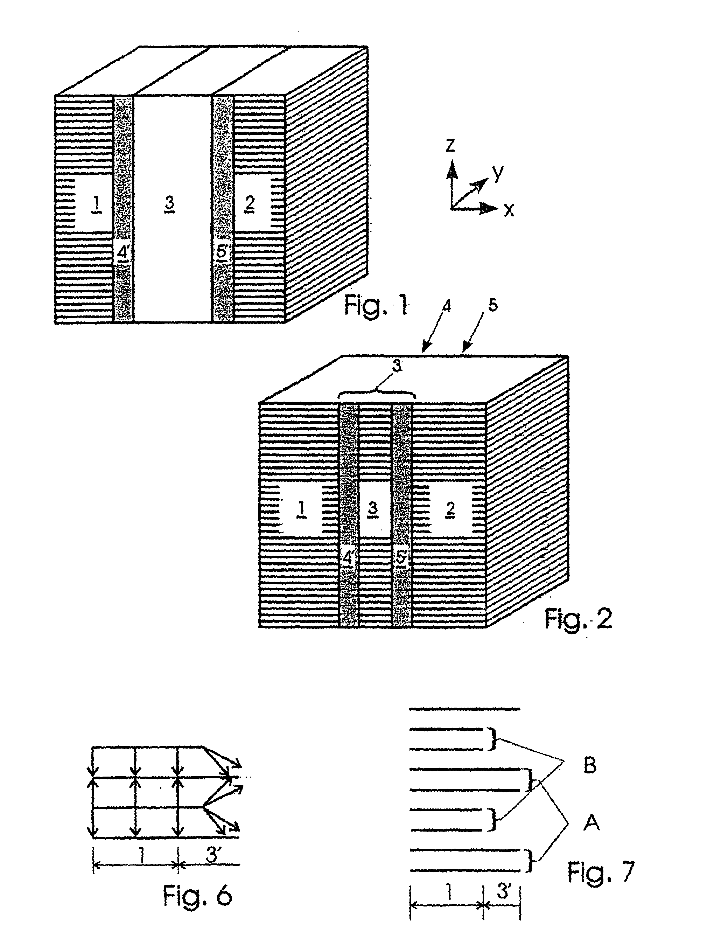

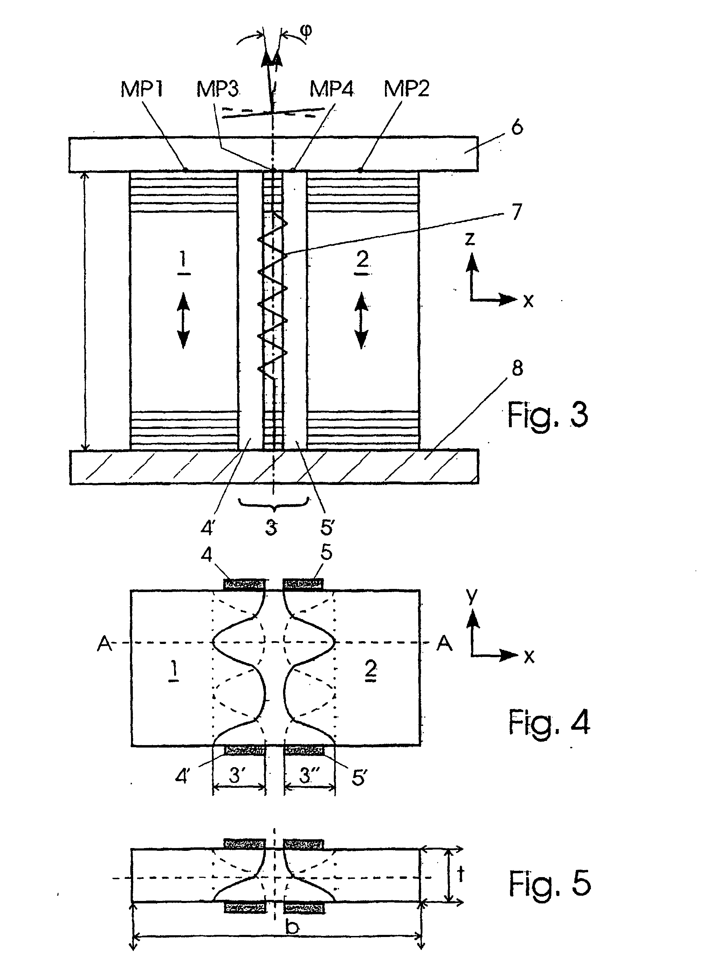

In Figur 1 ist ein grundsätzlicher Aufbau vorliegender Erfindung perspektivisch dargestellt. Dabei besteht der Antrieb aus zwei piezoelektrischen Stapeln, die aus einer Vielzahl übereinandergeschichteter und miteinander verbundener piezokeramischer Lamellen, die jeweils in der x-y-Ebene beidseitig flächig kontaktiert sind. Zwischen diese beiden Stapel ist formschlüssig mit diesen verbunden ein Bereich 3 eingebracht, dessen Seitenflächen deckungsgleich zu den jeweils anliegenden Seitenflächen der Stapelbereiche 1, 2 ausgeführt sind. Die äußere Kontaktierung der einzelnen, stapelstimflächig endenden Lamellenelektroden erfolgt über den Gesamtstapel erfassende Elektroden 4' (4) und 5' (5), beispielsweise über eine belotete Sputterkontaktschicht. Gemäß der Erfindung sind diese Elektroden 4' (4), 5' (5) jedoch weitestgehend in den piezoelektrisch passiven Bereich 3 verlagert angeordnet.
Bevorzugt ist im Rahmen der Erfindung vorgesehen, wie in Fig. 2 angedeutet, daß die Bereiche 1, 2 und 3 durch einen einheitlichen Stapel aus jeweils ganzflächig die Bereiche 1, 3, 2 überdeckenden durchgängigen Laminatplättchen gebildet sind, wobei eine besondere Elektrodenstruktur zwecks Bildung eines piezoelektrisch passiven Bereichs 3 vorgesehen ist, die anhand von Fig. 4, 5, 6 und 7 näher beschrieben wird. Bei derartigen Ausbildungen kann eine vollständige Verlagerung der äußeren Elektroden 4', 5' in den piezoelektrisch weitestgehend passiven Bereich 3 realisiert werden.

Eine detailliertere Ausführung der Erfindung soll anhand von Fig. 3 beschrieben werden, die schematisch die Verwendungsmöglichkeit des Antriebs für einen Kippspiegel darstellt.

Der dargestellte Stapel mit seinen Bereichen 1, 2, 3 soll aus 160 piezokeramischen Folien einer Dicke von 100 µm bestehen. Die einzelnen Folien sind beidseitig mit einem periodisch wiederkehrenden Kontaktstrukturenverlauf, wie in Fig. 4 näher dargestellt, derart versehen, daß ihnen im Gebiet des passiven Bereichs 3 ein periodisch strukturierter Verlauf in einer zweiten Dimension (y-Richtung) gegeben ist, der derart ausgeführt ist, daß Maxima der einen Elektrodenstruktur mit Minima der benachbarten zugehörigen anderen Laminatelektrodenstruktur zusammenfallen. Die Folien werden so übereinander gestapelt und verfügt, daß die Kontaktstrukturen benachbarter Folien deckungsgleich übereinanderliegen und eine gemeinsame Elektrodenfläche bilden. Durch Teilung mit einer Trennsäge senkrecht zu den Elektrodenflächen (vgl. Trennlinie A-A in Fig. 4) entsteht als kleinstmögliche Einheit die in Fig. 5 dargestellte Querschnittsgeometrie. Durch Metallisierungen 4, 4' und 5, 5' in der Trennebene werden beidseitig die Elektrodenbeläge der Bereiche 1 und 2 so miteinander kontaktiert, daß geradzahlige und ungeradzahlige Kontaktebenen elektrisch miteinander verbunden sind. Durch Anlegen einer Spannung von 200 V an die Elektroden 4 und 4' sowie 5 und 5' erfolgt die Polarisation der Piezolamellen in den Bereichen, wo sich die geraden und ungeraden Kontaktebenen überdecken. So entsteht eine Ausbildung in den piezoelektrisch aktiven äußeren Bereichen 1 und 2 und dem piezoelektrisch passiven inneren Bereich 3 zwischen den Übergangsbereichen 3' und 3". Die äußeren elektrischen Anschlüsse 4, 4' und 5, 5' erfolgen über Lotverbindungen der vier Metallisierungen mit vier nicht dargestellten Anschlußdrähten. Der so entstandene Aktuator hat eine Geometrie von 1 = 16 mm, b = 14 mm und t = 2,5 mm. Aufgrund der Periodizität der Kontaktstrukturen sind ungeradzahlige Vielfache der Tiefe t ebenfalls funktionsfähig (vgl. Fig. 4). Der so geschaffene Aktuator ist grundsätzlich in zwei Betriebsarten betreibbar, wobei die nachfolgend beschriebene erste Betriebsart die im Rahmen vorliegender Erfindung anstrebenswerteste ist.
1. Betriebsart: Es erfolgt eine Spannungsbeaufschlagung mit antisymmetrischer Spannungsänderung von Bereich 1 von 0 ... 200 V bzw. von Bereich 2 von 200 ... 0 V;
2. Betriebsart: Es erfolgt eine Spannungsbeaufschlagung mit symmetrischer Spannungsänderung von Bereich 1 und 2 zwischen 0 ... 200 V.

An den in Fig. dargestellten Meßpunkten MP1 bis MP4 werden folgende Längenänderung gemessen:

| | MP1 | MP2 | MP3 - | MP4 |
|---|---|---|---|---|
| Betriebsart 1 | 17,7 µm | 17,9 µm | 0,5 µm | 6 µm |
| Betriebsart 2 | 16,0 µm | 16,5 µm | 12,5 µm | 11,0 µm, |

wobei die jeweilig angegebenen Längenänderungen jeweils für den mit Meßtoleranzen versehenen Maximalhub in den einzelnen Bereichen stehen.

In der Betriebsart 1 ergibt sich eine große antisymmetrische Längenänderung im Bereich der Meßpunkte 1 und 2. In der Symmetrieachse, am Meßpunkt MP3 zeigt sich praktisch keine Längenänderung. Im Bereich der äußeren Anschlüsse 4, 4' und 5, 5' (MP4) ist die Längenänderung auf ca. ein Drittel und damit sehr stark gegenüber der Längenänderung in den Bereichen 1 und 2 (MP1, MP2) reduziert. Die aus den Messungen resultierende Verkippung der Oberfläche beträgt ± 0,11°. Mit einem solchen Antrieb ist bspw. ein Kippspiegel betreibbar, dessen Auslenkungen oberhalb einer massearmen, biegesteifen Druckplatte 6 in Fig. 3 angedeutet ist.

In der Betriebsart 2 ergibt sich eine symmetrische Dehnung von 1 ‰ der Länge mit einer leichten Reduzierung der Dehnung im Bereich 3 (MP3 und MP4). Der erfindungsgemäße Aktuator ist somit auch wie ein nach dem Stand der Technik aufgebauter Einzelaktuator betreibbar.

Wird dieser Stapel mit einer biegesteifen massearmen Druckplatte 6, die mit einer Basisplatte 8 über Spannmittel 7 verbunden ist, mit einer symmetrisch wirkenden Kraft von etwa 800 N vorgespannt, die Kippungen um die Symmetrieachse oder Hübe zuläßt, so erhöht sich der maximale Kippwinkel auf *ϕ* = ±0,2° bzw. der erreichbare Hub in z-Richtung auf 28 µm. Eine solche Anordnung weist eine sehr hohe Resonanzfrequenz von ≈ 20 kHz in beiden Betriebsarten auf

Weitere Variationsmöglichkeiten der erfindungsgemäßen flächigen Elektrodenausbildungen bezogen auf den Bereich 3 sind in den Figuren 6 und 7 schematisch angedeutet. Dabei sind in Fig. 6 altenierende unterschiedlich lange Kontaktschichtausbildungen von positiven und negativen Elektroden in x-Richtung dargestellt, wodurch das elektrische Feld in den Bereich 3' (respektive des nicht dargestellten Bereichs 3") abfällt, was eine geringere Dehnung dieser Gebiete- zur Folge hat. In Figur 7 sind Elektrodenausführungen dargestellt, bei denen im Übergangsbereich 3' kontaktierte Scheibenbereiche (A) mit in diesem Bereich 3' unkontaktierten Scheibenbereichen (B) abwechselnd vorgesehen sind. Die erfindungsgemäße Folge des Abfalls des elektrisch wirkenden Feldes in den Übergangsbereich 3' (resepktive des hier ebenfalls nicht dargestellten Bereiches 3") ist vergleichbar mit der zu Fig.6 beschrieben. Weitere Varianten der unterschiedlichen Elektrodenausbildung in x-Richtung liegen im Rahmen der Erfindung gemäß Folgenden ansprüchen.

## Patentansprüche

1. Piezoaktuatorisches Antriebs- oder Verstellelement auf der Basis von piezoelektrischen Stapeln, die aus einer Vielzahl jeweils beidseitig flächig kontaktierter, rechteckiger piezoelektrischer Lamellen bestehen, wobei die äußere Kontaktierung von einzelnen, stapelstirnflächig endenden Lamellenelektroden, die mit der gleichen Polarität beaufschlagbar sein sollen, durch den Gesamtstapel erfassende, untereinander durchgängig verbundene Elektroden in Form von aufgebrachten Metallisierungen (4, 4', 5, 5') erfolgt, wobei wenigstens zwei piezoelektrisch aktive Bereiche (1, 2) solcher piezoelektrischer Stapel vorgesehen sind, zwischen denen ein piezoelektrisch passiver Bereich (3) angeordnet ist, der Gebiete (3', 3") beinhaltet, die vom elektrischen Feld, herrührend von den spannungsbeaufschlagten flächigen Laminatkontaktierungen, die so strukturiert sind, daß in den Gebieten (3', 3") an den Außenkanten feldfreie und im Inneren wenigstens ein feldbehaftetes Gebiet enthalten ist, nur teilweise erfaßt oder unerfaßt sind und die äußeren Elektroden (4, 4', 5,5') der Bereiche (1, 2) weitestgehend in Richtung der genannten feldreduzierten bzw. feldfreien Gebiete verlagert sind, wobei der passive Bereich (3) mit den aktiven Bereichen (1 und 2) zumindest formschlüssig verbunden ist.

2. Piezoaktuatorisches Antriebs- oder Verstellelement nach Anspruch 1, **dadurch gekennzeichnet, daß** der passive Bereich (3) mit den aktiven Bereichen (1 und 2) auch stoffschlüssig derart verbunden ist, daß ein einheitliches, die Bereiche (1, 3, 2) bildendes Laminatschichtpaket vorgesehen ist, wobei die Laminatkontaktierungsbelegungen im passiven Bereich (3) unterbrochen ausgeführt sind und die äußeren Elektroden (4, 4', 5, 5') der aktiven Bereiche (1, 2) ausschließlich im vom passiven Bereich (3) erfaßten Gebiet vorgesehen sind.

3. Piezoaktuatorisches Antriebs- oder Verstellelement nach Anspruch 1 oder 2, **dadurch gekennzeichnet, daß** die positiven und negativen Elektroden der Laminatkontaktierungsbelegungen zueinander einen geometrischen seitlichen Versatz in einer ersten Dimension (x-Richtung) aufweisen.

4. Piezoaktuatorisches Antriebs- oder Verstellelement nach Anspruch 3, **dadurch gekennzeichnet, daß** die Elektroden der Laminatkontaktierungsbelegungen aufeinanderfolgender Laminate zueinander einen Versatz in genannter erster Dimension (x-Richtung) aufweisen.

5. Piezoaktuatorisches Antriebs- oder Verstellelement nach einem der Ansprüche 3 oder 4, **dadurch gekennzeichnet, daß** die Elektroden der Laminatkontaktierungsbelegungen der aktiven Bereiche (1, 2) in einer zur ersten Dimension (x-Richtung) senkrecht verlaufenden zweiten Dimension (y-Richtung) zueinander eine voneinander abweichende Formgebung aufweisen.

6. Piezoaktuatorisches Antriebs- oder Verstellelement nach Anspruch 5, **dadurch gekennzeichnet, daß** den Elektroden der Laminatkontaktierungsbelegungen im Gebiet des passiven Bereichs (3) ein periodisch strukturierter Verlauf in der zweiten Dimension (y-Richtung) gegeben ist, der derart ausgeführt ist, daß Maxima der einen Elektrodenstruktur mit Minima der benachbarten zugehörigen anderen Laminatelektrodenstruktur zusammenfallen.

7. Piezoaktuatorisches Antriebs- oder Verstellelement nach Anspruch 6, **dadurch gekennzeichnet, daß** Einzelstapelantriebe durch Trennung entlang einer Trennlinie A-A aus einem Gesamtblock bei Einhaltung eines ungeradzahligen Vielfachen einer kleinsten Periode (t) hergestellt sind.

## Claims

1. Piezo actuator drive or adjustment element on the basis of piezoelectric stacks which consist of multiple rectangular piezoelectric laminae which are each contacted on both sides, whereby the external contacting of individual, laminae electrodes which finish on the front side of the stack and to which voltage should be applied with the same polarity ensues through electrodes connected through the whole stack and continuously connected with one another in the form of applied metallisations (4, 4' 5, 5'), whereby at least two piezoelectrically active domains (1, 2) of such piezoelectric stacks are provided, between which a piezoelectrically passive domain (3) is located containing regions (3', 3") which are partially or not at all exposed to the electric field coming from the flat laminae contacts where voltage is applied and which are structured in such a way that in the regions (3', 3 ") there is a field-free region on the outside edges and on the inside there is at least one region which is field-exposed and the external electrodes (4, 4', 5, 5') in domains (1, 2) are displaced as far as possible in the direction of the aforementioned field-reduced or field-free regions, whereby the passive domain (3) is at least in positive fit to the active domains (1 and 2).

2. Piezo actuator drive or adjustment element according to Claim 1, **characterised** therein that the passive domain (3) is connected with the active domains (1 and 2) and made of the same material so that a uniform laminae layer package which forms the domains (1, 3, 2) is provided, whereby the electrical contact areas of the laminae in the passive domain (3) are equipped with interruptions and the external electrodes (4, 4', 5, 5') in the active domains (1, 2) are provided exclusively in the region included by the passive domain (3).

3. Piezo actuator drive or adjustment element according to Claim 1 or 2 **characterised** therein that the positive and negative electrodes of the electrical contact areas of the laminae show a geometrically lateral offset in the first dimension (x-direction) to one another.

4. Piezo actuator drive or adjustment element according to Claim 3 **characterised** therein that the electrodes of the electrical contact areas of successive laminae show an offset in the aforesaid first dimension (x-direction).

5. Piezo actuator drive or adjustment element according to one of the Claims 3 or 4, **characterised** therein that the electrodes of the electrical contact areas of the laminae of the active domains (1, 2) show a deviation in shape from one another in a second dimension (y-direction) running perpendicular to the first dimension (x-direction).

6. Piezo actuator drive or adjustment element according to Claim 5 **characterised** therein that the electrodes of the electrical contact areas of the laminae in the region of the passive domain (3) are given a periodically structured pattern in the second dimension (y-direction) which is constructed in such a way that the maxima of the one electrode structure coincide with the minima of the neighbouring related other electrode structure of the laminae.

7. Piezo actuator drive or adjustment element according to Claim 5 **characterised** therein that single stack drives are produced when a complete block is cut along dividing line A-A, adhering to an odd numbered multiple of the smallest period (t).

## Revendications

1. Elément piézo-électrique de commande ou de réglage basé sur les piles piézo-électriques, qui sont composées d'une multitude de couches piézo-électriques rectangulaires chacune portant une électrode de surface sur les deux faces, et où les contacts extérieurs de ces électrodes de surface individuelles qui viennent se terminer sur la face frontale de la pile et sur lesquelles il est possible d'appliquer la même polarité, sont réalisés par des électrodes s'étendant sur la longueur de la pile et reliées ensemble de manière continue, sous forme de métallisations (4, 4', 5, 5') et où au moins deux domaines piézo-électriques actifs (1, 2) de telles piles piézo-électriques sont prévues, entre lesquelles un domaine piézoélectriquement passif (3) est disposé qui contient des domaines (3', 3") qui ne sont pas ou peu touchés par le champ électrique provenant des électrodes de surface où une tension est appliquée et qui sont structurées de telle façon que dans les domaines (3', 3") aux bords extérieurs il n'y a pas de champ électrique et qu'à l'intérieur existe au moins un domaine avec champ électrique ; les électrodes extérieures (4, 4', 5, 5') des domaines (1, 2) sont déplacées autant que possible en direction des domaines cités sans champ électrique ou avec un champ électrique réduit ; le domaine passif (3) est en contact mécanique avec les domaines actifs (1 et 2) au moins de manière à former un bloc uniforme.

2. Un élément piézo-électrique de commande ou de réglage selon la revendication 1 est **caractérisé en ce que** le domaine passif (3) est non seulement relié aux domaines actifs (1 et 2) de façon à former un bloc uniforme, mais aussi réalisé dans le même matériau ce qui donne un ensemble de couches homogène constituant les domaines (1, 3, 2) ; les électrodes de surface des couches dans le domaine passif (3) sont exécutées de manière interrompue et les électrodes extérieures (4, 4', 5, 5') des domaines actifs (1, 2) sont prévues uniquement dans la région du domaine passif (3).

3. Un élément piézo-électrique de commande ou de réglage selon la revendication 1 ou 2 est **caractérisé en ce que** les électrodes positives et négatives des surfaces de contact des couches montrent un déplacement latéral géométrique les unes par rapport aux autres dans une première dimension (direction x).

4. Un élément piézo-électrique de commande ou de réglage selon la revendication 3 est **caractérisé en ce que** les électrodes des surfaces de contact des couches montrent un déplacement des couches successives les unes par rapport aux autres dans la première dimension citée (direction x).

5. Un élément piézo-électrique de commande ou de réglage selon l'une des revendications 3 ou 4 est **caractérisé en ce que** les électrodes des surfaces de contact des couches des domaines actifs (1, 2) montrent une divergence de forme les unes par rapport aux autres dans une deuxième dimension (direction y) perpendiculaire à la première dimension (direction x).

6. Un élément piézo-électrique de commande ou de réglage selon la revendication 5 est **caractérisé en ce que** les électrodes des surfaces de contact des couches au niveau du domaine passif (3) possèdent un tracé structuré périodique dans la deuxième dimension (direction y) qui est exécuté de telle façon que les maxima de l'une des structures d'électrodes coïncident avec les minima de l'autre structure voisine d'électrodes de surface.

7. Un élément piézo-électrique de commande ou de réglage selon la revendication 6 est **caractérisé en ce que** les commandes de piles individuelles sont construites en coupant un bloc entier le long d'une ligne de coupure A-A et en respectant un multiple impair d'une plus petite période (t).
